# EUROPEAN PATENT APPLICATION

(11) **EP 0 904 923 A1**
(43) Date of publication of application: **31.03.1999**
(21) Application number: 98307890.8
(22) Date of filing: 29.09.1998
(51) Int. Cl.: B29C 45/58, B29C 45/56

(54) **Method and system for molding**

(30) Priority: 30.09.1997 US 60560 P
(71) Applicant: TEXAS INSTRUMENTS INCORPORATED, Dallas Texas 75265 (US)
(72) Inventor: Libres, Jeremias P., Dallas, Texas 75243 (US); Bolanos, Mario A., Plano, Texas (US); Attarwala, Abbas I., Fremont, California 94536 (US)
(74) Representative: Darby, David Thomas

(57) **Abstract**

A mold system (20) to impede the formation of internal voids in a solidified molding material (60) is provided. Mold system (20) includes a mold (21) having at least one mold cavity (28). A transfer system (25) communicates or transfers non-solidified molding material (60) into mold cavity (28). A frequency system (70) applies a wave energy (72) to non-solidified mold material (60) contained within mold cavity (28). Wave energy (72) implodes or breaks up entrained air and bubbles (62) in non-solidified molding material (60) that may cause internal voids.

## Description

### FIELD OF THE INVENTION

This invention relates generally to the molding of plastics and more particularly to the application of vibration waves during the process of molding plastics or other materials.

### BACKGROUND OF THE INVENTION

Plastics, or polymers, are used in a variety of products and applications ranging from the simple pen to the complicated wing of an aircraft. Different types of plastics, or polymers, as they are technically known, generally have different mechanical, chemical, and electrical properties that allow plastics to be used in many applications. Plastics are typically formed into a product through a molding process, such as transfer molding, injection molding, sheet molding, or blow molding.

For example, plastics are used extensively in the computer and semiconductor industry in a wide variety of applications. One such application is the encapsulation of semiconductor devices, particularly integrated circuits. Encapsulating a semiconductor device in plastic materials protects the device from environmental damage and also provides structural strength to the semiconductor device.

Conventional molding systems and processes suffer from numerous disadvantages. One disadvantage of conventional molding systems and processes is the formation of internal voids, or inner voids, in the molded product. Internal voids are bubbles and clusters of bubbles of air in the molded product that affect the intended use of the molded product.

Internal voids often degrade mechanical, electrical, and chemical properties of the semiconductor device, as well as the appearance of the molded product. In the case of encapsulated semiconductor devices or packages, internal voids reduce the reliability of the package because they allow moisture to accumulate within the voids. This moisture may cause corrosion of the semiconductor device and may promote cracking when the encapsulated semiconductor device is subjected to a vapor phase reflow or a similar process.

Although internal voids may be detected by x-ray or similar equipment, the tests are often expensive and greatly increase the overall cost of the molded package. As the semiconductor industry continues to increase the number of leads by decreasing the gap between the leads, the ability to manufacture an encapsulated package without internal voids between the leads becomes increasingly more difficult.

### SUMMARY OF THE INVENTION

Accordingly, a need has arisen for an improved molding system and method. A molding system and method is disclosed herein that addresses shortcomings of prior molding systems and processes.

A method for molding includes forming a mold containing at least one mold cavity. Molding material is transferred into each mold cavity, and wave energy is applied to the molding material contained within each mold cavity to impede the formation of internal voids within the molding material.

A molding system is also provided to impede the formation of internal voids in a molding material that encapsulates a semiconductor device includes a mold having a mold cavity contained within the mold. A transfer system is connected to the mold cavity through a runner system. The transfer system operates to transfer non-solidified molding material into the mold cavity. The non-solidified molding material contained within the mold cavity encapsulates the semiconductor device. A frequency system applies vibration waves to the non-solidified molding material disposed within the mold cavity.

The invention provides several technical advantages. For example, the invention improves the quality of the finished molded product by reducing or eliminating internal voids, at least in part, breaking up large bubbles formed by the clustering or grouping of small bubbles. The invention also prevents the formation of large bubbles caused by back pressure and flow stoppage at the completion of cavity filling and allows an even dispersion of small voids, which do not result in internal voids. In addition, the invention allows the density of the molded product, or package density, to be increased. The increase in package density allows the encapsulation of a next generation of semiconductor devices that have an ever increasing number of leads.

### BRIEF DESCRIPTION OF THE DRAWINGS

The present invention will now be further described by way of example with reference to the accompanying drawings in which:
FIGURE 1 is a drawing in section with portions broken away showing, in part, a mold system prior to transfer of a molding material into a mold cavity;
FIGURE 2 is a cross section of a complete mold system taken in part along lines 2-2 of FIGURE 1;
FIGURE 3 is a drawing in section with portions broken away showing the mold system of FIGURE 1 during transfer of molding material into the mold cavity;
FIGURE 4 is a drawing in section with portions broken away showing the mold system of FIGURE 3 after molding material has been transferred into the mold cavity and also showing application of wave energy to the molding material; and
FIGURE 5 is a partial drawing in section with portions broken away of a mold system

### DETAILED DESCRIPTION OF INVENTION

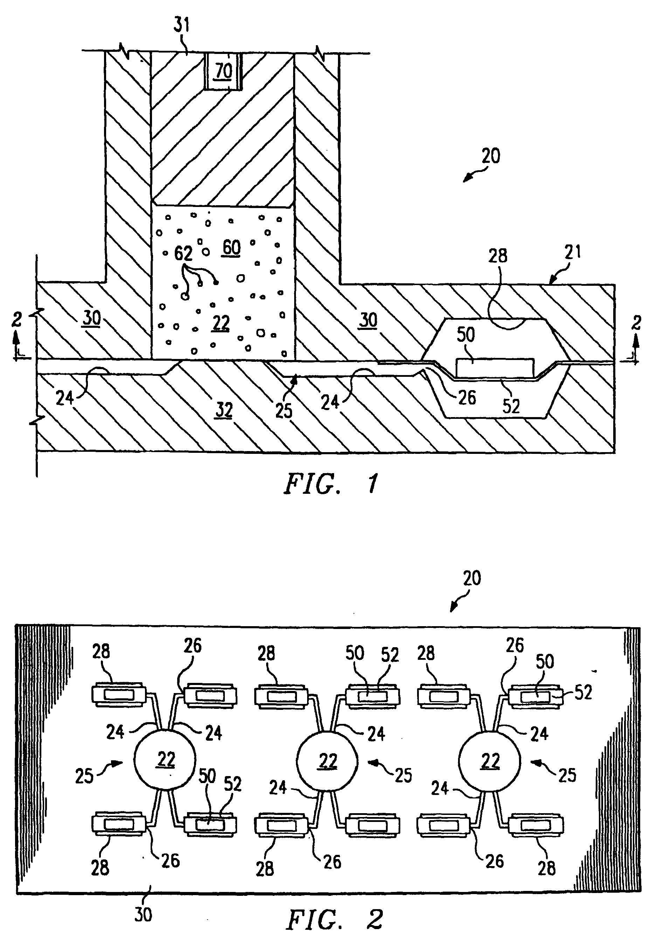

Embodiments of the system and method and advantages are best understood by referring in more detail to FIGURES 1 through 5 of the drawings, in which like numerals refer to like parts throughout the several views.

The invention relates to the formation of internal voids in a solidified molding material or package. It has been determined that internal voids are formed by the grouping or clustering of small air bubbles and voids when a mold cavity is filling with non-solidified molding material. The non-solidified molding material then solidifies or hardens with internal voids in the solidified molding material or package. The grouping of small bubbles into larger sizes, thereby forming internal voids, is often caused by back pressure when the flow of non-solidified molding material into the mold cavity stops at the completion of mold cavity filling. In addition, the formation of small bubbles when the non-solidified molding material is flowing is inherent to the molding process. Small bubbles are formed as the molding material begins to flow to the mold cavity. Wave energy is applied to the molding material contained within the mold cavity to reduce or eliminate small bubbles and voids that may group or cluster to form internal voids.

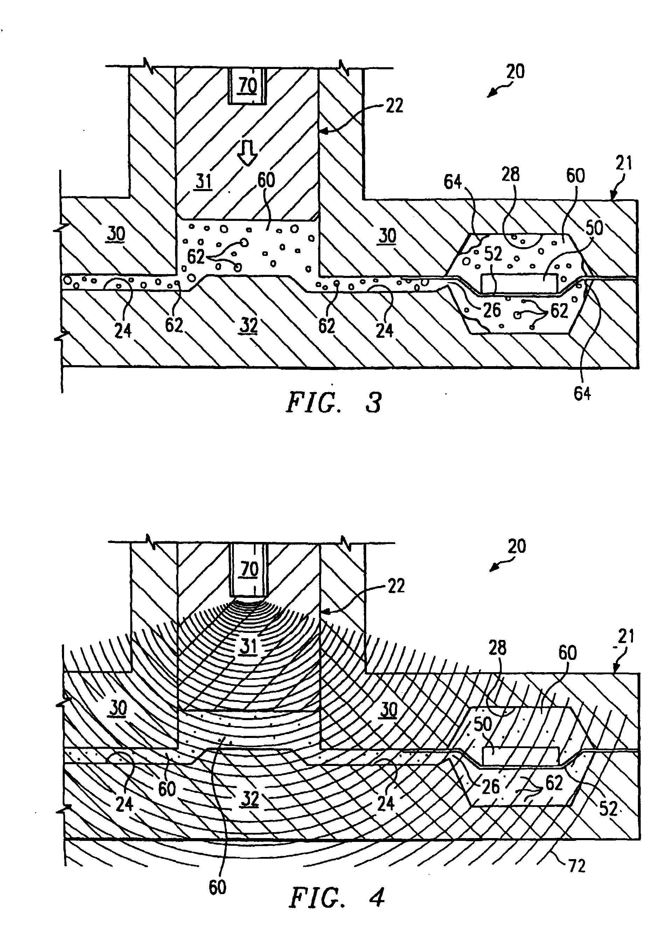

FIGURE 1 is a schematic cross section in part of one embodiment of a mold system 20, and FIGURE 2 is a cross section of mold system 20 taken along line 2-2 of FIGURE 1. Mold system 20 may include a mold 21 having a mold cavity 28, a transfer system 25 to transfer mold material 60 into mold cavity 28, and a frequency system 70 to apply wave energy 72, as illustrated in FIGURE 4, to mold material 60 within mold cavity 28.

Mold 21 may include a first chase 30 and a second chase 32, which cooperate to form a system of passages and cavities between the chases. As best illustrated in FIGURE 2, mold cavity 28 is connected to a pot 22 by a runner system 24. Runner system 24 includes gate 26, which forms the transition of runner system 24 to mold cavity 28.

Mold 21, as illustrated in FIGURE 2, is a multipot mold; however, the teachings may be applied to other mold designs, including single pot molds, pencil molds, and gauged pot molds. Although pot 22 is shown as part of first chase 30, pot 22 may also be formed as part of second chase 32. As illustrated in FIGURE 1 and as discussed in greater detail below, pot 22 stores molding material 60 for use in mold system 20. Pot 22 may be formed in any shape or size suitable for molding applications. A plunger 31 corresponding to the shape and size of pot 22 may be slidably disposed within pot 22 to apply a compressive load to molding material 60 contained within pot 22.

Molding material 60 is disposed within pot 22 between plunger 31 and runner system 24. FIGURE 1 illustrates plunger 31 in a non-compressive load position, in which plunger 31 is not applying a compressive load to molding material 60 contained within pot 22. Molding material 60 may be any type of plastic or polymer, such as thermosets or thermoplastics. Prior to the molding process, molding material 60 may be in the form of powder, granules, cold compacted powder, or a liquid. Powder and granule molding materials 60 may contain 30-50% of entrained air. Cold compacted powder molding materials 60 may contain 10-20% of entrained air, whereas liquid molding materials 60 contain much less entrained air 62.

A lead frame 52 may be loaded between first chase 30 and second chase 32. Lead frame 52 may include multiple semiconductor devices 50. When first chase 30 and second chase 32 are assembled together, mold cavity 28 is formed around semiconductor device 50.

As best illustrated in FIGURE 2, transfer system 25 may be any device or system operable to transfer non-solidified mold material 60 into mold cavity 28. Transfer system 25 may include plunger 31 in cooperation with pot 22 and runner system 24 that communicates non-solidified molding material 60 from pot 22 to mold cavity 28.

FIGURES 3 and 4 are schematic cross sections in part of one embodiment of a mold system 20 during the molding process. FIGURE 3 illustrates mold system 20 during transfer of molding material 60 from pot 22 to mold cavity 28, which is commonly referred to in the art as the transfer phase.

FIGURE 4 illustrates mold system 20 after transfer of molding material 60 into mold cavity 28, during compression of molding material 60 and during the application of wave energy 72 to molding material 60. Compression of molding material 60 is commonly referred to in the art as the packing phase. Frequency system 70 is operable to apply wave energy 72 to molding material 60 contained within mold cavity 28. For example, frequency system 70 may include a high frequency horn that is directly or indirectly attached to plunger 31; a transducer that is connected to plunger 31; or a servo-valve connected to a hydraulic system that provides the compressive load to plunger 31; however, frequency system 70 may include other transducers and techniques for applying wave energy 72 to molding material 60 contained within mold cavity 28.

Wave energy, as used herein, may be energy of any suitable wave type, frequency, and intensity that reduces or prevents the formation of internal voids. In one embodiment, wave energy 72 may be vibration waves greater than 1,000 cycles per second; however, ultrasonic waves, which are waves greater than 20 kHz, have been found to be particularly effective in reducing internal voids 62. Vibration waves, as used herein, may include both longitudinal waves, which are alternating waves of rarefaction and compression, and transverse waves, which are shear waves perpendicular to the direction of compressive wave propagation.

The peak-to-peak intensity of wave energy 72 may be varied depending upon the application. For example, wave energy 72 may be a square wave wherein the intensity of wave energy 72 is constant, a ramping wave wherein the intensity of wave energy 72 ramps from low to high or vice versa, or a sinusoidal wave wherein the intensity of wave energy 72 varies according to a sinusoidal wave. A wave energy 72 intensity greater than 20 kHz is preferable; however, a wave energy 72 intensity of 5 kHz, 10 kHz, and 15 kHz may be used with the present invention.

In one embodiment, wave energy 72 may have a frequency that matches, or is a multiple of, a natural frequency of molding material 60 or mold cavity 28. The natural frequency of mold material 60 is defined herein to be that frequency or frequency range that best implodes entrained air or bubbles 62 in mold material 60, thereby preventing internal voids in the molded package. Because mold material 60 may contain different fillers, different mold materials 60 may have different natural frequencies. The natural frequency of mold cavity 28 is defined herein to include those frequencies or frequency ranges that amplify wave energy 72 within mold cavity 28.

The duration of wave energy 72 may also be varied. Wave energy 72 may be applied continuously, in pulses, or a combination of continuous and pulse. Continuous application of wave energy 72, as used herein, is the application of wave energy 72 during the molding process for a single discrete time period. The continuous application of wave energy 72 may include varying the intensity of wave energy 72 during the continuous application of wave energy 72. The pulse application of wave energy 72, as used herein, is the application of wave energy 72 during discrete time periods with discrete time periods between each pulse that wave energy 72 is not applied. The intensity of wave energy 72 during each pulse of wave energy 72 may be varied.

Wave energy 72, whether applied continuously or pulsed may be applied at any time during the molding process. For example, wave energy 72 may be applied during the transfer phase at a constant intensity to reduce the formation of bubbles 62 and to help transfer molding material 60 from pot 22 to mold cavity 28 through runner system 24. Wave energy 72, with the pulses having a different intensity, may then be applied during the packing phase to break up and implode bubbles 62 that cause internal voids in molding material 60 within mold cavity 28.

Continuous application of ultrasonic wave energy 72 at approximately 220 kHz with an intensity of approximately 165 watts for 120 seconds has been found to be particularly advantageous. In such an embodiment, bubbles 62 imploded, reducing entrained air in molding material 60 by 40%-60%. Embodiments utilizing pulsed application of wave energy 72 at 220 kHz with an intensity ranging from 165-225 watts for 60 seconds are also particularly advantageous and have produced similar reductions in the number of entrained air bubbles 62. Although particular frequencies and intensities are described, other frequencies and intensities may be used.

In operation, molding material 60 is placed within pot 22 between plunger 31 and runner system 24, as illustrated in FIGURE 1. Pot 22 may contain a heating element to melt molding material 60. In addition, mold 20 may contain a heating element to elevate the temperature of mold 21 to accelerate the molding process. During the transfer phase, as illustrated in FIGURE 3, plunger 31 extends toward runner system 24, thereby applying a compressive load to non-solidified molding material 60 contained within pot 22. In response to the compressive load from plunger 31, non-solidified molding material 60 flows through runner system 24 and gate 26 into mold cavity 28. A flow front 64 is formed at the leading edge of non-solidified molding material 60 as it flows through the runner system 24 and into mold cavity 28. Flow front 64 captures air during the transfer phase and is characterized by a frothy appearance. When non-solidified molding material 60 essentially fills mold cavity 60, the momentum of molding material 60 can cause back pressure in mold cavity 28, which disrupts the flow of non-solidified molding material 60 and causes additional bubbles 62 to be formed in mold material 60. The entrained air or bubbles 62 are preferably eliminated or reduced in size to avoid internal voids.

During the packing phase, as illustrated in FIGURE 4, plunger 31 extends farther toward runner system 24, increasing the compressive load on non-solidified molding material 60 contained within pot 22. The increased pressure is communicated through runner system 24 to mold cavity 28, thereby increasing the compressive pressure on non-solidified molding material 60 within mold cavity 28. Although packing is not always a necessity, its purpose is to help reduce the entrained air or bubbles 62 that cause internal voids by compressing air bubbles 62.

As best illustrated in FIGURE 4, wave energy 72 may be applied at the packing phase of the molding process. Wave energy 72 implodes or breaks up bubbles 62 that may cause internal voids. Wave energy 72 also increases the package density of solidified molding material 60 by vibrating or pulsating non-solidified molding material 60 into the minute details of mold cavity 28. Non-solidified molding material 60 is then allowed to solidify or harden, for example, by cooling, at which time first chase 30 and second chase 32 of mold 21 may be separated to allow the removal of the encapsulated semiconductor device or package.

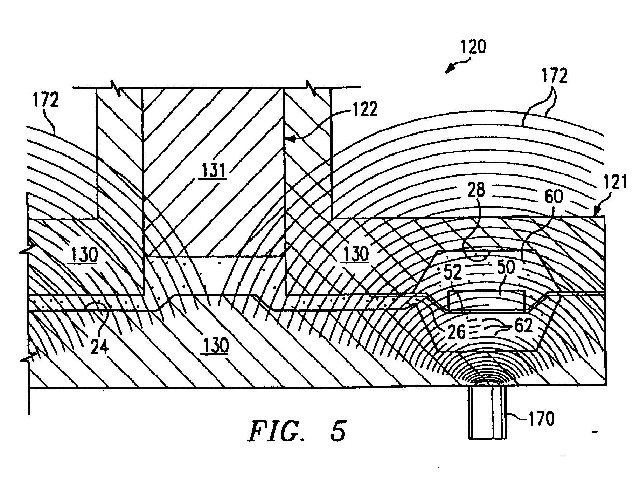

FIGURE 5 is a schematic cross section in part of a mold system 120. Mold system 120 is analogous to mold system 20, except that frequency system 170, which is analogous to frequency system 70, is associated with a mold 121. The operation of mold system 120 as shown in FIGURE 5 is analogous to mold system 20, described above.

The invention provides an efficient and effective method and system for reducing or eliminating air bubbles or voids that may cause internal voids in a final molded product. In addition, the present invention increases the quality of the final molded product.

## Claims

1. A method of molding, comprising the steps of:
forming a mold having a mold cavity;
transferring molding material into the mold cavity; and
applying wave energy to the molding material within the mold cavity, the wave energy being arranged to impede the formation of internal voids within the molding material.

2. The method of Claim 1, wherein the step of applying wave energy to the molding material comprises applying vibration waves to the molding material.

3. The method of Claim 2, wherein the step of applying vibration waves comprises applying vibration waves at frequency of approximately 20 kHz cycles per second.

4. The method of Claim 2, wherein the step of applying vibration waves to the molding material comprises applying ultrasonic waves.

5. The method of any of Claims 1 to 4, wherein the step of applying wave energy to the molding material comprises applying wave energy at a frequency corresponding to a natural frequency of the molding material.

6. The method of any of Claims 1 to 5, wherein the step of applying wave energy to the molding material comprises applying wave energy at a frequency approximately equal to a natural frequency of the mold cavity.

7. A molding system for impeding the formation of internal voids in a molding material, the molding system comprising:
a mold having a mold cavity disposed within the mold;
a transfer system connected to the mold cavity for transfering a non-solidified molding material into the mold cavity, for encapsulating an semiconductor device; and
a frequency system operable to apply vibration waves in the non-solidified molding material disposed within the mold cavity to impede the formation of internal voids in the molding material.

8. The molding system of Claim 7, wherein the frequency system comprises an ultrasonic transducer for applying vibration waves.

9. The molding system of Claim 8, wherein the ultrasonic transducer is connected to the mold.

10. The molding system of Claim 8 or Claim 9, wherein the ultrasonic transducer is coupled to the transfer system.
